# EUROPEAN PATENT APPLICATION

(11) **EP 4 797 902 A1**
(43) Date of publication of application: **26.08.2026**
(21) Application number: 26158227.4
(22) Date of filing: 12.02.2026
(51) Int. Cl.: H10D 30/01, H10D 30/66, H10D 62/40, H10D 62/832

(54) **POWER ELECTRONIC DEVICE WITH CURRENT SPREADING REGIONS AND CORRESPONDING MANUFACTURING PROCESS**

(30) Priority: 20.02.2025 IT 202500003363
(71) Applicant: STMicroelectronics International N.V., 1228 Plan-les-Ouates, Geneva (CH)
(72) Inventor: CAMALLERI, Cateno Marco, 20864 Agrate Brianza (MB) (IT); GUARNERA, Alfio, 20864 Agrate Brianza (MB) (IT); SCALIA, Laura Letizia, 20864 Agrate Brianza (MB) (IT); ZANETTI, Edoardo, 20864 Agrate Brianza (MB) (IT); SAGGIO, Mario Giuseppe, 20864 Agrate Brianza (MB) (IT)
(74) Representative: Studio Torta S.p.A.

(57) **Abstract**

A process for manufacturing a power electronic device (100) having a plurality of elementary cells, envisages: providing a substrate (2), having a first electrical conductivity (n) and a first doping value and defining a front surface (1a); forming first CSL - Current Spreading Layer - regions (6) in a deep position of the substrate (2) at a distance from the front surface (1a), having the first electrical conductivity (n) and a second doping value, greater than the first doping value; forming first doped regions (10) of elementary cells of the power electronic device (100) above the first current spreading regions (6), having a second conductivity type (p) and separated from each other in a direction (x) parallel to the front surface (1a) by intercell regions (2') of the power electronic device (100); forming second CSL - Current Spreading Layer - regions (16) at the intercell regions (2'), having the first electrical conductivity (n) and distinct and independent characteristics with respect to the first current spreading regions (6).

## Description

### TECHNICAL FIELD

The present solution relates to a power electronic device with current spreading regions and to a corresponding manufacturing process; in particular, reference will be made in the following discussion, without thereby any loss of generality, to a power electronic device provided starting from a substrate of silicon carbide, SiC.

### BACKGROUND

As is known, semiconductor materials having a wide band gap, for example greater than 1.1 eV, low on-state resistance, high thermal conductivity, high operating frequency and high saturation velocity of charge carriers allow to obtain electronic devices, for example diodes and transistors, which may have better performances than silicon electronic devices, in particular for power applications, for example with operating voltages comprised between 600 V and 1300 V and/or in specific operating conditions such as high temperature conditions.

In particular, such power electronic devices may advantageously be provided starting from a wafer of silicon carbide, a material having indeed the characteristics listed above, in one of its polytypes, for example 3C-SiC, 4H-SiC and 6H-SiC.

In a known manner, power electronic devices may include current spreading regions (so-called CSL - Current Spreading Layer - regions), having a suitable doping in order to locally modulate the resistivity of the substrate, causing the injected current to spread uniformly across respective portions of the same substrate. For example, in a MOSFET power transistor device, CSL regions may be formed in the intercell (or JFET) areas to reduce the on-state resistance (Rₒₙ).

The process for manufacturing such power electronic devices envisages, typically in an initial step, the formation of a uniform current spreading layer by a dedicated epitaxial growth, performed starting from the substrate, for example made of silicon carbide.

In particular, in order to obtain a desired resistance value, the formation of a thick epitaxial layer is required, so that, typically, at least two epitaxial growths need to be performed, to reach the desired thickness.

This manufacturing solution entails times and costs which are quite high, since the process recipe and parameters have to be controlled to implement a second epitaxial growth, independently of, and in addition to, a first epitaxial growth.

As an alternative to epitaxial growth, the implementation of a traditional ion implant has been proposed for forming the current spreading layer, this implant being performed at high energy and high temperature.

However, this solution is particularly complex, given that several implant steps are typically required for forming a uniform doping profile layer (in this regard, it is highlighted that the diffusion of dopants is not an applicable technique due to the low diffusivity in silicon carbide, compared to other semiconductor materials, such as silicon).

A further solution that has been proposed, for example in EP 4 425 562 A1 in the name of the same Applicant, envisages the formation of CSL regions by a channeled ion implantation process (in the so-called "channeling" condition), i.e. with the direction of the implanted ion beam oriented along one of the crystallographic axes of the semiconductor material, substantially parallel thereto.

As is known, when implanted in the crystal lattice, the ions generally tend to disperse due to impacts with the atoms of the crystal lattice (according to the phenomenon of impact scattering). When the implant direction is oriented to an oblique angle with respect to the main axes of the crystal lattice, the atoms in the lattice have a random spreading with respect to the implant direction; the probability of collisions between the implanted ions and the atoms of the crystal lattice is therefore substantially uniform as the depth varies. In this implant condition, substantially Gaussian doping profiles are obtained with respect to the depth direction, and the depth reached by the implant is determined by the energy, the ions used and the atomic structure of the target.

If the implant direction is instead a channeling direction, proximate to a main axis of the crystal lattice, the atoms in the crystal lattice define "channels" that may be traversed by the implanted ions; this reduces the probability of collisions between the implanted ions and the atoms of the crystal lattice, especially near the surface of the wafer wherein the implant occurs, so that the depth of the same implant may be increased.

In general, implant channeling occurs when the implant direction is within a critical angle with respect to the channeling direction. In this configuration, the loss of electron energy (interaction with the electron clouds of the crystal atoms) is prevalent with respect to the nuclear loss (impacts with the crystal nuclei). The value of the critical angle depends, for example, on the direction, the species and the energy used.

As used herein, the term "implant angle" refers to the tilt angle of the wafer that is used during the implant and may be defined in general as an angle with respect to the surface of the wafer. In general, the surface of the wafer is not a crystallographic plane, as it is defined by a cut angle suitable for subsequent epitaxial processes, for example 4° (in this example, therefore, to identify the <0001> direction of the crystal lattice during the implant, the wafer needs to be tilted with a tilt angle of 4°).

In the above patent application, it has also been proposed to provide the CSL regions in a localized manner with respect to the JFET areas of the power electronic device.

The distinct CSL regions allow to suitably reduce the resistivity of the JFET areas, without at the same time varying the characteristics of the substrate portions underlying the body regions, in particular without increasing their doping and without varying the characteristics of the body/drain junctions.

Although certainly advantageous, the aforementioned solution also has some issues, in particular related to a possible reduction in the reliability of the resulting power electronic devices and to the possibility of drift of the on-state resistance (Rₒₙ) in the presence of high operating temperatures.

### SUMMARY

The present solution has the aim of solving, at least in part, the previously highlighted issues, providing an alternative manufacturing solution for the current spreading regions in a power electronic device, for example made from silicon carbide.

According to the present solution, a power electronic device and a corresponding manufacturing process are therefore provided, as defined in the attached claims.

### BRIEF DESCRIPTION OF THE FIGURES

For a better understanding of the present invention, a preferred embodiment thereof is now described, purely by way of non-limiting example and with reference to the attached drawings, wherein:

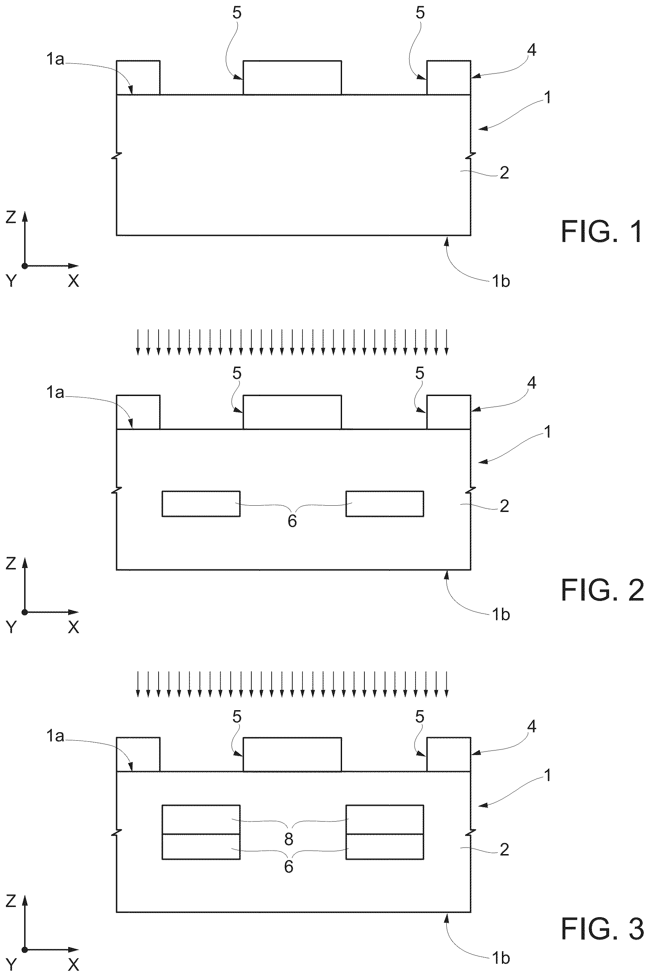

- Figures 1 to 10 are cross-sections of a wafer of semiconductor material, in consecutive steps of a manufacturing process of a power electronic device, according to an embodiment of the present solution.

### DESCRIPTION OF EMBODIMENTS

As will be described in detail below, an aspect of the present solution envisages the formation, in a power electronic device (in a possible example, to which reference will be made below, of the MOSFET type, made of silicon carbide) of different and distinct current spreading regions (CSL regions), located respectively in the intercell (JFET) portions and in the portions underlying the body regions of the same power electronic device.

In particular, such distinct CSL regions allow to independently define, in a precise and desired manner, the dopant concentration in the respective portions of the power electronic device (intercell portions and portions underlying the body regions), so as to define the electrical properties and characteristics of the same power electronic device.

With reference to Figure 1, a possible embodiment of the present solution is now described, which first envisages providing a wafer 1 of semiconductor material, comprising a substrate 2 and delimited by a front surface 1a and a back surface 1b, having main extension in a horizontal plane xy and opposite to each other along a vertical axis z, orthogonal to the horizontal plane xy.

In a possible implementation, this substrate 2 is made of silicon carbide, for example of the 4H-SiC type having a doping with n-type conductivity.

In particular, the crystallographic lattice of the silicon carbide may be oriented by a certain angle (not zero) with respect to the surface of the wafer 1. In a possible implementation, the lattice structure has an "off-cut" angle of about 4° (intended as the angle between the surface of the wafer 1 and the main crystallographic plane, for example along the <0001> direction).

As shown in the same Figure 1, an implant mask 4, so-called "hard mask", is formed above the front surface 1a of the wafer 1, for example by deposition of a thick oxide layer; the hard mask defines openings 5 at which, as will be discussed below, respective elementary cells of the power electronic device will be formed (this implant mask 4 therefore defines the arrangement of the aforementioned elementary cells of the power electronic device).

In a manner not illustrated in detail, the openings 5 may have a parallel strip shape, with an elongated extension along a first horizontal axis (in the example the y-axis) of the aforementioned horizontal plane xy (in particular, this extension may correspond substantially to an entire extension of the wafer 1 along the aforementioned y-axis).

According to an aspect of the present solution, as shown in Figure 2, using the implant mask 4, an implant in channeling condition is performed for the formation of first current spreading regions (CSL) 6, at the openings 5 of the implant mask 4; these first CSL regions 6 have n-type conductivity and a first doping, greater than that of the substrate 2 (therefore operating as an enrichment layer).

In particular, the first CSL regions 6 are formed at a certain depth of the substrate 2, that is, at a given distance from the front surface 1a (such depth may for example be comprised between 0.5 and 5 µm).

The aforementioned implant is performed at a certain angle (tilt angle) with respect to the direction orthogonal to the front surface 1a of the wafer 1, in such a way as to provide the channeling conditions and thus allow channeling of the implanted ions towards the depth of the substrate 2.

In the implementation previously discussed (with the 4H-SiC lattice and assuming that the implant is performed with atoms of phosphorus, P, with an implant energy for example comprised between 80 kev and 600 kev), the ion implant may be performed with a tilt angle comprised between 3.5° and 4.5°, for example equal to about 4°, so that the implantation occurs substantially in a channeled manner along the <0001> direction of the crystal lattice. The implant dose may be for example comprised between 1e12 and 1e14 and the implantation may be performed at room temperature.

In particular, the channeled ion implantation allows for very precise control of the doping of the current spreading regions, for example with variations lower than 1% with respect to a desired value; and also of the implant depth, again with variations lower than 1% with respect to a desired value.

With reference to Figure 3, the manufacturing process then proceeds with the formation of deep body regions 8, above the aforementioned first CSL regions 6, with an implant of p-type doping ions performed again through the implant mask 4 (possibly in channeling condition). These deep body regions 8 thus have a same extension (or width along the x axis) as the first CSL regions 6.

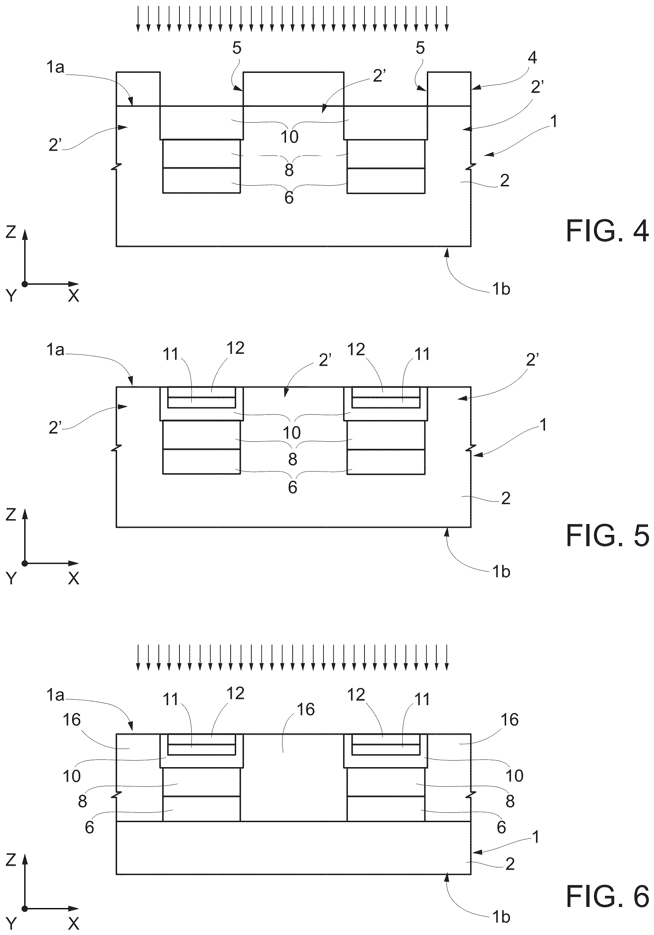

Subsequently, as indicated in Figure 4, body regions 10 are formed, at the front surface 1a of the wafer 1, above the aforementioned deep body regions 8, using an implantation of p-type doping ions through the implant mask 4 (such implantation being performed in a traditional manner, i.e. with a random ion implant, with a substantially zero tilt angle). Also these body regions 10 thus have substantially the same extension along the x axis as the first CSL regions 6.

The body regions 10 are separated from each other along a second axis of the horizontal plane xy (in the example along the x-axis), at a certain separation distance; in particular, the portions of the substrate 2 between adjacent body regions 10 and deep body regions 8, at the front surface 1a, are defined as intercell or JFET regions (indicated by 2').

Therefore, the first CSL regions 6 do not extend below the intercell or JFET regions 2', being confined below the body regions 10 and deep body regions 8, where they locally modulate the doping concentration and resistivity of the substrate 2.

The implant mask 4 is then removed from the front surface 1a of the wafer 1.

Subsequently, as shown in Figure 5, using a masked ion implant (in this case of the p⁺ type with a high doping dose), body contact regions 11 are formed within the body regions 10, centrally thereto and at a certain distance from the front surface 1a of the wafer 1. In a known manner, such body contact regions 11 have the purpose of providing an ohmic contact with the respective body regions 10.

As shown in the same Figure 5, source regions 12 are then formed within each body region 10 (centrally with respect thereto), at the front surface 1a of the wafer 1, by a further masked ion implant, in this case of the n-type (for example with nitrogen or phosphorus ions); such source regions 12 are therefore arranged above the aforementioned body contact regions 11.

Both implantations, for forming the body contact regions 11 and the source regions 12, are made in a traditional manner, not in channeling conditions.

According to an aspect of the present solution, as shown in Figure 6, the manufacturing process proceeds with an ion implantation in channeling condition, for forming second current spreading regions (CSL) 16, at, and in a localized manner with respect to, the aforementioned intercell or JFET regions 2'.

As previously discussed, the ion implant may be performed with a tilt angle comprised between 3.5° and 4.5°, for example equal to about 4°, in such a way that the implantation occurs substantially in a channeled manner along the <0001> direction of the crystal lattice. The implant energy and dose may be for example comprised between 30 kev and 600 kev and, respectively, between 1e12 and 1e14 and the implantation may be performed at room temperature.

In particular, the source regions 12 (and the body regions 10) are surface regions that are heavily damaged from the crystal lattice point of view, having been subject to previous doping for ion implantation (performed in the traditional manner, i.e. with a substantially zero tilt angle). The crystal lattice at these heavily damaged regions therefore represents a barrier to the implanted ions, which distribute randomly without penetrating in depth.

Consequently, the ion implantation in channeling condition is performed without the use of masks, in a self-aligned manner with respect to such source regions 12 and body regions 10, so that the implanted ions proceed in depth, in channeling condition, only at the JFET regions 2', for forming the aforementioned second CSL regions 16.

At the damaged regions, the implantation produces a profile with very small depth and a substantially negligible random implant peak, such as not to alter (or in any case modify in a limited and controllable manner) the doping of the source regions 12 (and of the body regions 10). Conversely, where the same damaged regions (which here act as an implant mask) are not present, a flat implant profile is generated along the depth of the substrate 2.

The depth of the ion implantation is therefore modulated in a self-aligned manner with respect to the aforementioned body and source regions 10, 12, without resorting to the use of implant masks.

In the illustrated example, the aforementioned second CSL regions 16 extend starting from the front surface 1a of the wafer 1 until reaching a depth substantially corresponding to the maximum depth reached by the first CSL regions 6 (in other words, a lower surface of the first and second CSL regions 6, 16 is substantially at a same distance from the front surface 1a). Furthermore, the second CSL regions 16 do not extend below the deep body regions 8.

Advantageously, the second CSL regions 16, having independent and distinct characteristics with respect to the first CSL regions 6, allow to reduce in a desired manner the resistivity of the JFET regions 2', without at the same time varying the characteristics of the portions of the substrate 2 underlying the body regions 10, in particular, without increasing their doping and without varying the characteristics of the body/drain junctions.

These second CSL regions 16 thus locally modulate the doping concentration and the resistivity of the JFET regions 2', independently from the adjustment of the resistivity of the substrate 2 locally performed by the first CSL regions 6.

The manufacturing process then proceeds with the formation of insulated gate structures and source (and body) contact structures on the front surface 1a of the wafer 1.

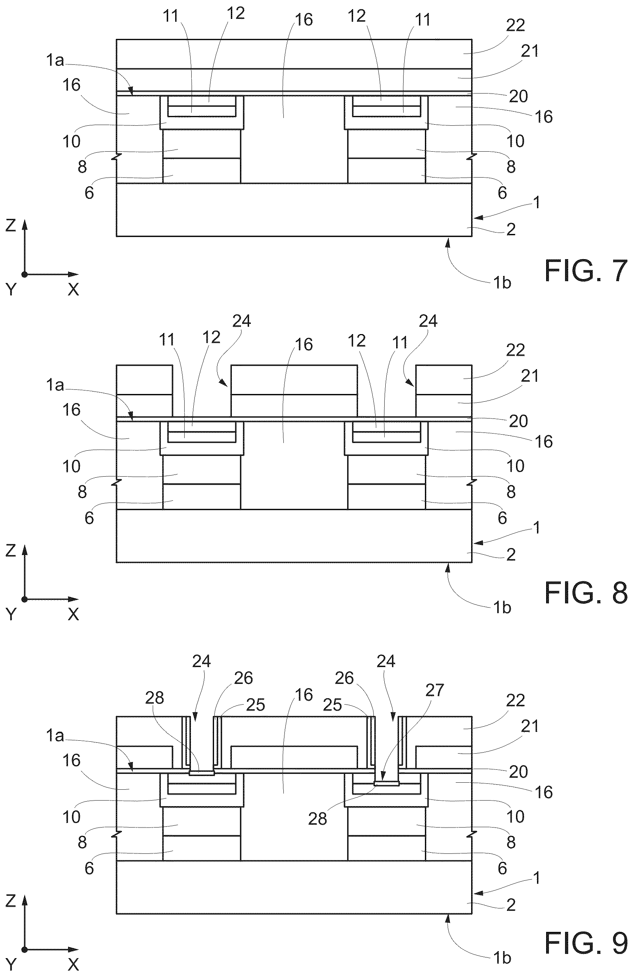

As shown in Figure 7, a gate oxide layer 20, a polysilicon layer 21 and a thick dielectric layer 22 (for example also of oxide), the so-called "interlayer" layer, are then formed in succession above the front surface 1a, by respective material depositions.

Subsequently, Figure 8, contact trenches 24 are opened through the aforementioned thick dielectric layer 22 and polysilicon layer 21, above the source regions 12 (i.e., at the cells of the power electronic device).

As shown in Figure 9, the following steps are then consecutively performed: oxidation of the polysilicon layer 21 (internally to the aforementioned contact trenches 24); deposition of a silicon nitride (SiN) layer 25, internally to the walls of the contact trenches 24; deposition of oxide spacers 26, on the internal side walls of the same contact trenches 24, internally with respect to the silicon nitride layer 25; etching for the formation of micro-trenches 27 at the bottom of the same contact trenches 24, reaching the source regions 12 or the body contact regions 11 (in alternating cells along the aforementioned x-axis); formation of silicide regions 28, in particular nickel silicide, at the bottom of the same micro-trenches 27, for electrical contacting alternatively the source regions 12 or the body contact regions 11.

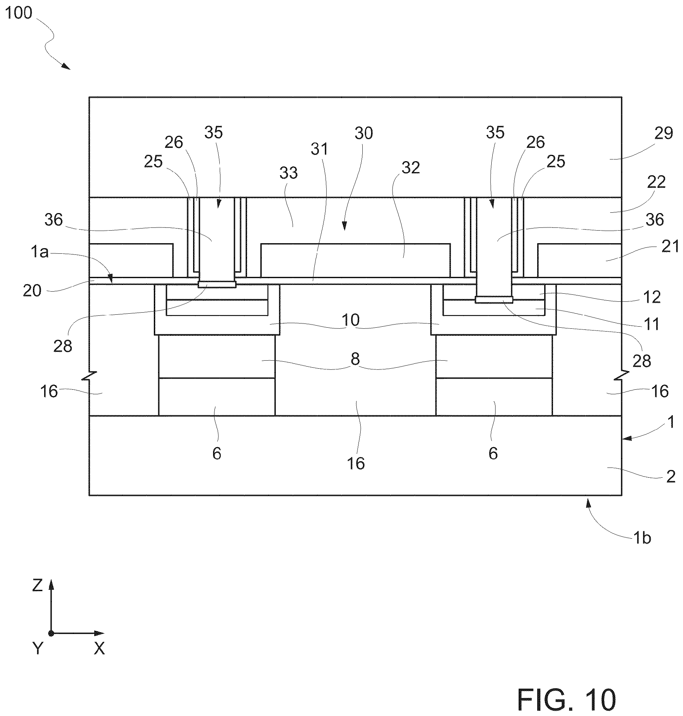

As shown in Figure 10, the manufacturing process then envisages deposition of a metal layer 29 above the aforementioned thick dielectric layer 22, which also fills the contact trenches 24 (and micro-trenches 27, contacting the aforementioned source regions 12 and body contact regions 11) .

In particular, the aforementioned insulated gate regions, denoted by 30, are therefore defined by: a gate insulating region 31, in the example of oxide, in contact with the front surface 1a of the wafer 1, above a respective JFET region; a gate conductive region 32, directly arranged on the gate insulating region 31, of a conductive material, in the example of polysilicon; and a passivation region 33 (in the example of thick oxide), covering the gate conductive region 32 and enclosing, together with the gate insulating region 31, the gate conductive region 32. The gate conductive regions 32 of the insulated gate structures 30 are electrically connected in parallel, in a manner here not shown, forming a gate terminal of the power electronic device.

The aforementioned source (and body) contact structures, denoted by 35, are in turn formed by the aforementioned metal layer 29 and by metal filling regions, indicated by 36, within the aforementioned contact trenches 24 (and micro-trenches 27).

In a manner not illustrated, a further metallization region may be formed on the back surface 1b of the wafer 1, to define a drain terminal of the same power electronic device.

Each elementary cell of the power electronic device, in the example of the MOSFET type, indicated as a whole in Figure 100 by 100, is therefore formed by an insulated gate structure 30 and by the adjacent portions of the body 10 and source 12 regions, as well as by the underlying JFET region.

The advantages of the proposed solution are clear from the preceding description.

In any case, it is emphasized that the presence of the distinct first and second CSL regions 6, 16, having different and independent characteristics (for example in terms of doping and arrangement within the substrate 2), respectively in the portions of the substrate 2 underlying the body regions 10 and in the intercell or JFET portions 2', generally allows to improve the electrical performance of the resulting power electronic device 100.

The first CSL regions 6 below the body regions 10 allow to avoid drifts of the on-state resistance (Rₒₙ) of the power electronic device 100 and also to set the parameters of the same device more accurately. In particular, these first CSL regions 6 affect the on-state resistance (Rₒₙ) and its behavior in temperature, but also the breakdown voltage, forming a diode junction with the respective deep body regions 8.

Moreover, the second CSL regions 16, formed by channeled ion implantation self-aligned to the doped regions formed prior to the same implantation, allow to adjust the doping profile in a more accurate manner, especially in the case of "scaled" devices (i.e. devices with small dimensions), and also to obtain the desired effect of reducing the resistivity of the JFET regions 2', without however degrading the characteristics of the junction between body and drain.

Finally, it is clear that modifications and variations may be made to what has been described and illustrated herein without departing from the scope of the present invention, as defined in the attached claims.

In particular, the described solution may also find advantageous application in different power electronic devices, for example in diodes or JFET transistors, or generally in power devices having a strip arrangement for the corresponding elementary cells.

The channeled ion implantation may be performed with different doping ions, for example with nitrogen atoms (instead of phosphorus atoms). The use of phosphorus may however be advantageous for the resulting flat doping profile of the current spreading layer.

Moreover, the wafer 1 of semiconductor material from which the power electronic device 100 is obtained may be made by a material other than SiC, such as for example GaN or silicon.

## Claims

1. A process for manufacturing a power electronic device (100) having a plurality of elementary cells, comprising:
- providing a substrate (2), having a first electrical conductivity (n) and a first doping value and defining a front surface (1a);
- forming first CSL - Current Spreading Layer - regions (6) in a deep position of said substrate (2) at a distance from the front surface (1a), having the first electrical conductivity (n) and a second doping value, greater than the first doping value;
- forming first doped regions (10) of elementary cells of said power electronic device (100) above said first current spreading regions (6), having a second conductivity type (p), said first doped regions (10) being separated from each other in a direction (x) parallel to said front surface (1a) by intercell regions (2') of said power electronic device (100);
- forming second CSL - Current Spreading Layer - regions (16) at said intercell regions (2'), having the first electrical conductivity (n) and distinct and independent characteristics with respect to said first current spreading regions (6).

2. The process according to claim 1, wherein forming the second current spreading regions (16) comprises performing a channeled ion implantation, in a channeling condition, for the implantation of doping ions having said first electrical conductivity (n) within said substrate (2) starting from said front surface (1a); said channeled ion implantation being performed in a self-aligned manner with respect to said first doped regions (8, 10);
and wherein forming the first doped regions (10) comprises performing an implantation not in channeling condition and said first doped regions (10) are damaged regions of the crystallographic lattice of the substrate (2), such as to block a propagation of said channeled ion implantation along a vertical axis (z) orthogonal to said front surface (1a) in the direction of the depth of said substrate (2); said channeled ion implantation consequently having an implant profile with small depth and substantially negligible implant peak at said first doped regions (10).

3. The process according to claim 2, wherein said second current spreading regions (16) are configured to locally modulate the resistivity of said intercell regions (2') and do not extend in said substrate (2) below said first doped regions (8, 10).

4. The process according to any of claims 2-3, wherein said channeled ion implantation is performed along an implantation direction tilted by a non-zero tilt angle with respect to said front surface (1a).

5. The process according to any of the preceding claims, comprising forming an implant mask (4) above said front surface (1a), defining openings (5) at the elementary cells of the power electronic device (100); wherein forming the first current spreading regions (6) comprises performing a channeled ion implantation, in a channeling condition, for implanting doping ions having said first electrical conductivity (n) within said substrate (2) starting from said front surface (1a), said channeled ion implantation being performed through said implant mask (4).

6. The process according to any of the preceding claims, wherein said power electronic device (100) is a MOSFET transistor and said first doped regions comprise body regions (10) of said power electronic device (100) arranged at said front surface (1a); further comprising: forming deep body regions (8) interposed between said body regions (10) and said first current spreading regions (6) along a vertical axis (z) orthogonal to said front surface (1a); and forming source regions (12) and body contact regions (11) within said body regions (10), in proximity to the front surface (1a), by implantation not in channeling condition.

7. The process according to any of the preceding claims, wherein said second current spreading regions (16) extend starting from the front surface (1a) until reaching a depth in said substrate (2) substantially corresponding to the depth of the first current spreading regions (6).

8. The process according to any of the preceding claims, wherein said substrate (2) comprises silicon carbide.

9. A power electronic device (100), having a plurality of elementary cells and comprising:
- a substrate (2), having a first electrical conductivity (n) and a first doping value and defining a front surface (1a);
- first CSL - Current Spreading Layer - regions (6) arranged in a deep position of said substrate (2) at a distance from the front surface (1a), having the first electrical conductivity (n) and a second doping value, greater than the first doping value;
- first doped regions (10) of the elementary cells of said power electronic device (100) arranged above said first current spreading regions (6), having a second conductivity type (p), said first doped regions (10) being separated from each other in a direction (x) parallel to said front surface (1a) by intercell regions (2') of said power electronic device (100); and
- second CSL - Current Spreading Layer - regions (16) arranged at said intercell regions (2'), having the first electrical conductivity (n) and distinct and independent characteristics with respect to said first current spreading regions (6).

10. The device according to claim 9, wherein said first doped regions (10) are damaged regions of the crystallographic lattice of the substrate (2); and wherein said first current spreading regions (6) have an extension along said direction (x), which corresponds to that of said first doped regions (10).

11. The device according to claim 9 or 10, wherein said first doped regions (10) are configured to modulate the resistivity of the substrate (2) locally below said first doped regions (10); and wherein said second current spreading regions (16) are configured to locally modulate the resistivity of said intercell regions (2') and do not extend in said substrate (2) below said first doped regions (10).

12. The device according to any of claims 9-11, wherein said power electronic device (100) is a MOSFET transistor and said first doped regions comprise body regions (10) of said power electronic device (100) arranged at said front surface (1a); further comprising: deep body regions (8) interposed between said body regions (10) and said first current spreading regions (6) along a vertical axis (z) orthogonal to said front surface (1a); and source regions (12) and body contact regions (11) arranged within said first doped regions (10), in proximity to the front surface (1a); wherein said source regions (12) and body contact regions (11) are damaged regions of the crystallographic lattice of the substrate (2).

13. The device according to any of claims 9-12, wherein said first and second current spreading regions (6, 16) have respective and different doping concentrations.

14. The device according to any of claims 9-13, wherein said second current spreading regions (16) extend in said substrate (2) starting from the front surface (1a) until reaching a depth substantially corresponding to the depth of the first current spreading regions (6).

15. The device according to any of claims 9-14, wherein said substrate (2) comprises silicon carbide.
